# EUROPÄISCHE PATENTSCHRIFT

(11) **EP 0 864 177 B1**
(45) Veröffentlichungstag und Bekanntmachung des Hinweises auf die Patenterteilung: **06.02.2002**
(21) Anmeldenummer: 96946022.9
(22) Anmeldetag: 28.11.1996
(51) Int. Cl.: H01L 27/112

(54) **FESTWERT-SPEICHERZELLENANORDNUNG UND VERFAHREN ZU DEREN HERSTELLUNG**
READ-ONLY MEMORY CELL ARRAY AND METHOD FOR THE FABRICATION THEREOF
GROUPEMENT DE CELLULES DE MEMOIRE MORTE ET PROCEDE DE FABRICATION CORRESPONDANT

(30) Priorität: 28.11.1995 DE 19544327
(43) Veröffentlichungstag der Anmeldung: 16.09.1998
(73) Patentinhaber: Infineon Technologies AG, 81669 München (DE)
(72) Erfinder: KLOSE, Helmut, Ponghkupsie, NY 12603 (US)
(74) Vertreter: Zedlitz, Peter, Dipl.-Inf.
(86) Internationale Anmeldenummer: DE9602287
(87) Internationale Veröffentlichungsnummer: WO9720337

(56) Entgegenhaltungen:
- US-A- 4 198 693
- US-A- 4 263 663
- US-A- 5 300 804
- PATENT ABSTRACTS OF JAPAN vol. 012, no. 232 (E-628), 30.Juni 1988 & JP 63 024660 A (TOSHIBA CORP;OTHERS: 01), 2.Februar 1988,
- PATENT ABSTRACTS OF JAPAN vol. 009, no. 284 (E-357), 12.November 1985 & JP 60 124970 A (MATSUSHITA DENSHI KOGYO KK), 4.Juli 1985,
- PATENT ABSTRACTS OF JAPAN vol. 095, no. 006, 31.Juli 1995 & JP 07 057480 A (SHARP CORP), 3.März 1995,

## Beschreibung

Die Erfindung bezieht sich auf eine Festwert-Speicherzellenanordnung mit einem aus Halbleitermaterial bestehenden Substrat, welches im Bereich einer Hauptfläche in einem Zellenfeld angeordnete Speicherzellen aufweist, wobei jede Speicherzelle jeweils wenigstens einen MOS-Transistor mit einem Sourcegebiet, einem Draingebiet, einem Kanalgebiet, einem Gatedielektrikum und einer Gateelektrode aufweist, wobei das Draingebiet mit einer Bitleitung und die Gateelektrode mit einer Wortleitung verbunden ist, und der MOS-Transistor durch einen von der Hauptfläche des Substrates ausgehenden Graben, der bis zu dem Sourcegebiet reicht, ausgebildet ist, und wobei die Seitenwände des Grabens des MOS-Transistors unter einem Winkel von etwa 45° bis etwa 80° gegenüber der Hauptfläche des Substrates angeordnet sind, und mit einem Dotiermaterial einer vorbestimmten Leitfähigkeit zur Festlegung der Programmierung des MOS-Transistors dotiert sind.

Eine derartige Festwert-Speicherzellenanordnung und ein derartiges Verfahren zu deren Herstellung sind beispielsweise in den Patentanmeldungen der gleichen Anmelderin P 44 34 725 und P 44 37 581 beschrieben, auf welche verwiesen und vollinhaltlich Bezug genommen wird. Die auch als Nur-LeseSpeicher oder Read-Only-Memory bezeichneten Festwertspeicher finden zur Speicherung von Daten in vielen elektronischen Systemen Verwendung. Solche Speicher, bei denen die Daten in digitaler Form fest eingeschrieben sind, werden auf der Basis eines Halbleitermaterials, insbesondere Silizium, als integriert ausgebildete Silizium-Schaltungen realisiert, in welchen als Speicherzellen vorzugsweise MOS-Transistoren verwendet werden. Beim Auslesen werden die einzelnen Speicherzellen über die Gateelektrode der MOS-Transistoren, die mit einer Wortleitung verbunden ist, ausgewählt. Der Eingang jedes MOS-Transistors ist mit einer Referenzleitung verbunden, der Ausgang mit einer Bitleitung. Beim Lesevorgang wird bewertet, ob ein Strom durch den Transistor fließt oder nicht. Entsprechend werden den abgespeicherten Daten die logischen Werte Null und Eins zugeordnet. Technisch wird die Speicherung von Null und Eins bei diesen Festwert-Speichern dadurch bewirkt, daß in Speicherzellen, in denen der dem Zustand "kein Stromfluß durch den Transistor" zugeordnete logische Wert gespeichert ist, kein MOS-Transistor hergestellt wird oder keine leitende Verbindung zur Bitleitung realisiert wird. Alternativ können für die beiden logischen Werte entsprechend MOS-Transistoren realisiert werden, die durch unterschiedliche Implantationen im Kanalgebiet unterschiedliche Einsatzspannungen aufweisen. Ein solcher Siliziumspeicher besitzt einen im wesentlichen planaren Aufbau mit einem pro Speicherzelle minimalen Flächenbedarf, der bei etwa 4 bis 8 F² liegt, wobei F die in der jeweiligen Technologie kleinste herstellbare Strukturgröße bedeutet. Planare Festwert-Siliziumspeicher sind damit bei einer Ein-µm-Technologie auf Speicherdichten um etwa 0,14 Bit/µm² begrenzt.

Weitere Festwert-Speicherzellenanordnungen sind beispielsweise aus US 4,198,693; US 4,263,663; und US 5,300,804 bekannt. In den beiden zuerst genannten US-Patentschriften werden sogenannte VMOS Transistoren als MOS Transistoren verwendet, bei denen sich das Gate entlang V-förmig geneigter Seitenflanken von Gräben erstreckt und somit eine etwas höhere Packungsdichte erreichbar ist.

Der Erfindung liegt die Aufgabe zugrunde, eine Festwert-Speicherzellenanordnung und ein Verfahren zur Herstellung einer Festwert-Speicherzellenanordnung auf Halbleiterbasis zur Verfügung zu stellen, welche bzw. welches bei einer hohen Packungsdichte der Speicherzellen und einer hohen Ausbeute eine einfachere und kostengünstigere Fertigung bietet.

Diese Aufgabe wird durch eine Festwert-Speicherzellenanordnung gemäß Anspruch 1 und ein Verfahren gemäß Anspruch 5 gelöst.

Erfindungsgemäß ist vorgesehen, daß in dem Graben zumindest zwei MOS-Transistoren ausgebildet sind, die durch unterschiedliche Dotierung der beiden Seitenwände des Grabens unterschiedlich programmiert sind, so daß jeder MOS-Transistor eines Grabens in einem vorbestimmten Logikzustand aus einer mehrwertige Logikzustände besitzenden Zustandslogik, insbesondere einer vierwertigen Zustandslogik programmiert ist.

Bei einer insbesondere bevorzugten Ausführung der Erfindung beträgt der Winkel der Seitenwände des Grabens des MOS-Transistors gegenüber der Hauptfläche des Substrates etwa 70° bis etwa 80°, vorzugsweise etwa 75°. Durch die erfindungsgemäße Abschrägung der Seitenwände des Grabens kann eine fertigungstechnisch einfachere und damit kostengünstigere Programmierung der Grabentransistoren vorzugsweise vermittels Implantation bewerkstelligt werden, wobei gegenüber den an sich bekannten vertikal ausgebildeten Transistoren des Grabens lediglich eine geringfügig größere Speicherzellenfläche und damit nur geringfügig geringere Packungsdichte der Speicherzellen in Kauf genommen werden muß. Demgegenüber besteht bei vertikal ausgebildeten MOS-Transistoren in den Gräben bei der Programmierung vermittels Implantation die Schwierigkeit, die Seitenwände durch den senkrecht bezüglich der Substratoberfläche geführten Implantationsstrahles wirksam zu erreichen. Aus diesem Grund wird bei vertikal ausgebildeten Transistoren im allgemeinen lediglich der Boden des Grabens ordnungsgemäß implantiert, wobei aufgrund der bei der Implantation verwendeten Photolackmaske, welche in der Regel eine Dicke von etwa 1 bis 2 µm besitzt, zusätzlich Abschattungsprobleme bei der Implantation vorhanden sind. Erfindungsgemäß können nun auch die abgeschrägten Seitenflanken der Grabentransistoren implantiert werden, so daß die Einsatzspannung der Grabentransistoren wesentlich einfacher und genauer eingestellt werden kann.

Erfindungsgemäß sind weiterhin in jedem Graben zwei oder mehrere MOS-Transistoren ausgebildet, wobei durch eine zwei- oder mehrteilig aufeinanderfolgend ausgeführte Maskierung die beiden oder mehreren Seitenflanken eines Grabes getrennt voneinander durch Implantation eingestellt werden können. Auf diese Weise sind in einem Graben insbesondere zwei MOS-Transistoren ausgebildet, die durch unterschiedliche Dotierung der beiden Seitenwände des Grabens unterschiedlich programmiert sind. In diesem Fall können die in einem Graben ausgebildeten beiden MOS-Transistoren jeweils einen gemeinsamen Sourcebereich und einen gemeinsamen Gatebereich besitzen.

Darüber hinaus ist es aufgrund der erfindungsgemäßen Anordnung bzw. aufgrund des erfindungsgemäßen Verfahrens möglich, einem Transistor neben einer binären Einstellung mit den beiden Zuständen Null oder Eins durch Verfeinerung der Implantation auch einen vorbestimmten Logikzustand aus einer mehrwertige Logikzustände besitzenden Zustandslogik zuzuordnen, insbesondere einer vierwertigen Zustandslogik.

Die Erfindung eignet sich sowohl zur Herstellung von einmalig elektrisch programmierbaren Festwert-Speichern, bei denen das Gatedielektrikum insbesondere ein ONO-Formierungsmaterial (sogenannte OTP-Speicher = One-Time-Programmable-Memory) aufweist, oder, alternativ, zur Fertigung von maskenprogrammierbaren Festwert-Speichern (sogenannte maskenprogrammierbare ROM), bei denen das Gatedielektrikum insbesondere ein Gateoxid aufweist.

Zur Herstellung der Festwert-Speicherzellenanordnung werden in einem Siliziumsubstrat, das von einem ersten Leitfähigkeitstyp, beispielsweise vom Typ n⁺ dotiert ist, ein erstes dotiertes Gebiet und ein zweites dotiertes Gebiet erzeugt. Das erste dotierte Gebiet ist von einem zweiten, zum ersten entgegengesetzten Leitfähigkeitstyp dotiert, beispielsweise vom Typ p, und erstreckt sich vorzugsweise über das gesamte Zellenfeld. Es kann sowohl als entsprechend ausgedehnte Wanne als auch als durchgehende Schicht über das gesamte Substrat gebildet sein. Vorzugsweise erstreckt sich jeder Graben des Speicherzellenfeldes ausgehend von der Hauptfläche über die gesamte Tiefe des ersten dotierten Gebietes und reicht etwas in den Bereich des Siliziumsubstrates vom ersten Leitfähigkeitstyp hinein. Auf diese Weise kann der Bereich des Substrates vom ersten Leitfähigkeitstyp als gemeinsamer Sourcebereich für sämtliche Grabentransistoren eines Speicherzellenfeldes verwendet werden.

Das zweite dotierte Gebiet ist vom ersten Leitfähigkeitstyp, beispielsweise vom Typ n⁺ dotiert und grenzt an die Hauptfläche des Substrats an. Das zweite dotierte Gebiet dient als Drainanschluß der Grabentransistoren und ist elektrisch mit den Bitleitungen der Speicherzellen verbunden.

Des weiteren werden mehrere, im wesentlichen parallel verlaufende Isolationsbereiche erzeugt, welche einen parallel zur Hauptfläche gerichteten streifenförmigen Querschnitt aufweisen und über das gesamte Zellenfeld verlaufen. Diese Isolationsbereiche reichen von der Hauptfläche bis in das erste dotierte Gebiet hinein und dienen unter anderem zur elektrischen Isolation der einzelnen Speicherzellen.

Die Speicherzellen werden vorzugsweise in Zeilen und Spalten angeordnet. Zwischen je zwei Spalten ist jeweils ein Isolationsbereich angeordnet. Quer zu den Isolationsbereichen verlaufen Wortleitungen, mit denen die Gateelektroden der Speichertransistoren verbunden sind.

In vorteilhafter Weise können die Isolationsbereiche in solchen Abständen und mit solchen Breiten erzeugt werden, daß der Abstand zwischen benachbarten Isolationsbereichen im wesentlichen gleich der Breite der Isolationsbereiche ist. Des weiteren können die Gräben für die Speichertransistoren im Querschnitt parallel zur Hauptfläche gemessene lineare Abmessungen besitzen, die im wesentlichen gleich der Breite der Isolationsbereiche sind. Das bedeutet, die Gräben für die Speichertransistoren werden zum Beispiel pyramidenstumpfartig mit einer quadratischen Grundfläche mit einer Seitenlänge entsprechend der Breite der Isolationsbereiche oder kegelstumpfartig mit einem Durchmesser der Grundfläche entsprechend der Breite der Isolationsbereiche gefertigt. Der Mittelpunkt des Querschnitts der Grundfläche der Speicherzellengräben kann hierbei im Bezug auf die Mitte der Isolationsbereiche versetzt angeordnet sein.

Wird bei dieser Ausführungsform die Breite der Isolationsbereiche gleich der kleinsten, in der verwendeten Technologie herzustellenden Strukturgröße F erzeugt, so beträgt der Flächenbedarf einer Speicherzelle 2F². Bei dieser Ausführung der Erfindung wird ausgenutzt, daß die Justiergenauigkeit stets besser als die kleinste herstellbare Strukturgröße F ist. Bei einer Ein-µm-Technologie läßt sich damit eine Speicherzelle mit einer Fläche von 4 µm² zum Quadrat herstellen, so daß Speicherdichten von etwa 0,25 Bit/ µm² erzielt werden können.

Es liegt im Rahmen der Erfindung, bei der Herstellung des Zellenfeldes der Speicherzellenanordnung gleichzeitig MOS-Transistoren zur Ansteuerung der Speicherzellenanordnung an der Peripherie auf dem Substrat zu bilden. Das Gateoxid und die Gateelektroden der MOS-Transistoren in der Peripherie können hierbei mit den gleichen Prozeßschritten wie das Gateoxid und die Gateelektroden im Zellenfeld gebildet werden.

Weitere Merkmale, Vorteile und Zweckmäßigkeiten der Erfindung ergeben sich aus der nachfolgenden Beschreibung von Ausführungsbeispielen anhand der Zeichnung. Es zeigt:
- Figur 1: eine schematische Schnittansicht einer auf einem p/n⁺-Silizium-Wafer auszubildenden Festwert-Speicherzellenanordnung gemäß einem ersten Ausführungsbeispiel der Erfindung nach Definition der Isolationsbereiche mittels einer sogenannten Box-Isolation;
- Figur 2: eine schematische Schnittansicht des Wafers nach Ätzung der Gräben, wobei die Seitenwände der Gräben in einem Winkel von etwa 75° zur Hauptfläche des Substrats ausgeführt sind;
- Figur 3: eine schematische Schnittansicht des Wafers nach Definition der Einsatzspannung der Grabentransistoren und der planaren Peripherietransistoren, Gateoxid-bzw. ONO-Formierung, Abscheidung eines Gatepolysiliziums und Abdeckung mit einer SiO₂-Schicht, sowie Strukturierung mittels einer anisotropen Ätzung;
- Figur 4: eine schematische Schnittansicht des Wafers nach den Schritten Reoxidation, LDD-(Lightly-Doped-Drain)-Implantation und Spacer-(Abstandhalter)-Formierung, sowie Definition der Source/Draingebiete mittels einer Ionenimplantation;
- Figur 5: eine schematische Schnittansicht des Wafers nach Abscheidung einer SiO₂- bzw. TEOS-Schicht und Öffnung der zu kontaktierenden Source/Draingebiete;
- Figur 6: eine schematische Schnittansicht des Wafers nach Abscheidung einer Polysilizium-Schicht für die lokale Zwischenverbindung, Dotierung und Strukturierung;
- Figur 7: eine schematische Draufsicht einer Zelle des Festwert-Speichers gemäß dem ersten Ausführungsbeispiel der Erfindung nach Fertigstellung der lokalen Zwischenverbindung;
- Figuren 8A und 8B: schematische Draufsichten der Anordnung der Speicherzellen bei diagonal verlaufenden Bitleitungen; und
- Figuren 9A und 9B: schematische Draufsichten der Anordnung der Speicherzellen bei zickzackförmig verlaufenden Bitleitungen.

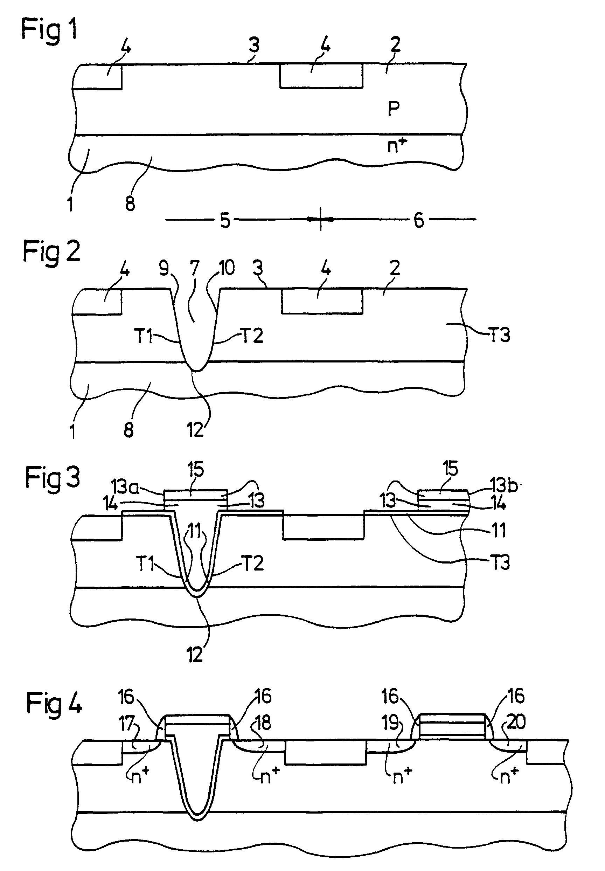

Auf einem Substrat 1 aus zum Beispiel n⁺-dotiertem monokristallinem Silizium mit einer Dotierstoffkonzentration von 1 x 10¹⁹cm⁻³ wird ein erstes dotiertes Gebiet 2 erzeugt. Das erste dotierte Gebiet 2 wird zum Beispiel p-dotiert mit einer Dotierstoffkonzentration von bespielsweise 5 x 10¹⁶cm⁻³ (siehe Figur 1). Das erste p-dotierte Gebiet 2 wird zum Beispiel durch eine ganzflächige oder maskierte Implantation mit Bor oder durch Aufwachsen von einer in situ p-dotierten Schicht mittels einer CVD-Epitaxie hergestellt. Das erste dotierte Gebiet 2 besitzt eine Hauptfläche 3 und weist eine senkrecht zur Hauptfläche 3 gemessene Stärke von beispielsweise 0,5 µm bis 1 µm auf. Unter Verwendung einer auf die Hauptfläche 3 aufgebrachten, der Übersichtlichkeit halber jedoch nicht näher dargestellten Maske werden Isolationsbereiche 4 zur Definition des Speicherzellenfeldes 5 bzw. zur Isolation von in einem Peripheriebereich 6 angeordneter Schaltungen gebildet, die streifenförmig über die Hauptfläche 3 verlaufen und ausgehend von der Hauptfläche 3 in die Tiefe teilweise in das erste dotierte Gebiet 2 reichen. Die Isolationsbereiche 4 bestehen beispielsweise aus SiO₂-Inseln.

Daran anschließend erfolgt unter Verwendung einer auf der Hauptfläche 3 aufgebrachten, der Übersichtlichkeit halber allerdings nicht näher dargestellten Grabenmaske die Fertigung von Gräben 7, vorzugsweise durch einen anisotropen Trockenätzprozeß. In denjenigem Teil des Substrats 1, in dem das Zellenfeld 5 gebildet wird, verlaufen die Gräben 7 streifenförmig über die Hauptfläche 3. Die Gräben 7 weisen eine Tiefe von zum Beispiel etwa 0,5 µm bis etwa 1 µm auf. Sie reichen bis in den n⁺-dotierten Bereich 8 des Substrats 1 hinein. Parallel zur Hauptfläche 3 weisen die Gräben 7 eine Breite von einer minimalen Strukturgröße F, zum Beispiel 0,6 µm und eine Länge von zum Beispiel 100 µm auf. Im Bereich eines Zellenfeldes 5 sind zum Beispiel 16 000 Gräben parallel nebeneinander angeordnet. Der Abstand zwischen benachbarten Gräben 7 beträgt wiederum eine minimale Strukturgröße, beispielsweise 0,6 µm. Die Ätzung der Gräben 7 erfolgt dergestalt, daß die Seitenwände 9 und 10 nicht senkrecht, sondern in einem Winkel von etwa 75° ausgeführt werden (siehe Figur 2). Diese Ätzung kann entweder durch entsprechende Parametereinstellung der jeweiligen Trockenätzung oder durch anisotrope chemische Ätzung wie zum Beispiel vermittels KOH realisiert werden.

Daran anschließend wird die Einsatzspannung der Grabentransistoren T1 und T2, sowie der außerhalb des Zellenfeldes 5 im Peripheriebereich 6 liegenden planaren Transistoren T3 über einen Implantationsschritt definiert. Hierzu wird auf die Hauptfläche 3 jeweils eine geeignete Implantationsmaske aufgetragen und strukturiert und eine Einstellung der Transistoren durch geeignete Dosiswahl der Implantation vorgenommen. Hierbei kann auch eine mehrfache Implantation bei einem Transistor realisiert werden, so daß die Herstellung einer mehrwertigen Speicherzelle, beispielsweise einer vierwertigen Speicherzelle möglich ist. Die Implantation kann beispielsweise mit Bor durchgeführt werden, wobei die Implantationsenergie beispielsweise etwa 25 keV und die Dosis beispielsweise 1 x 10¹²cm⁻³ betragen kann.

Daran anschließend erfolgt im Falle eines maskenprogrammierten Nur-Lese-Speichers eine Gateoxidabscheidung, oder, wie im Falle eines einmal elektrisch programmierbaren Nur-Lese-Speichers, eine ONO-Formierung. Im Falle der Herstellung eines Gateoxids wird nach Entfernen der Implantationsmaske beispielsweise eine thermische Oxidation bei zum Beispiel 750° C durchgeführt. Dabei entsteht an freiliegenden Siliziumflächen ein Gateoxid 11. Das Gateoxid 11 entsteht hierbei sowohl an den freiliegenden Siliziumflächen, die die Seitenwände 9, 10 und den Boden 12 der Gräben 7 bilden, als auch in dem Peripheriebereich 6 an der freiliegenden Oberfläche des ersten dotierten Gebietes 2. Wegen der unterschiedlichen Dotierung wächst das Gateoxid 11 in den Gräben 7 mit geringerer Dicke auf als auf der Oberfläche des Substrats 1. Anschließend wird ganzflächig eine leitfähige Schicht 13 aus zum Beispiel dotiertem Polysilizium abgeschieden. Die leitfähige Schicht 13 wird mit im wesentlichen konformer Kantenbedeckung abgeschieden. Die Stärke der leitfähigen Schicht 13 wird so eingestellt, daß die Gräben 7 vollständig aufgefüllt werden. Die Abscheidung der leitfähigen Schicht 13 erfolgt zum Beispiel in einem CVD-Verfahren mit SiH₄, wobei dem Prozeßgas als Dotierstoff Phosphor beigegeben wird. Die leitfähige Schicht 13 wird in einer Stärke von beispielsweise 400 nm abgeschieden. Daran anschließend wird eine nicht näher dargestellte Photolackmaske gefertigt. Unter Verwendung der Photolackmaske als Ätzmaske wird die leitfähige Schicht 13 in einem anisotropen Ätzprozeß, zum Beispiel mit Hbr, Cl₂ strukturiert. Hierbei werden im Bereich des Zellenfeldes 5 aus der leitfähigen Schicht 13 Wortleitungen 13a gebildet. Gleichzeitig werden im Bereich der Peripherie 6 Gateelektroden 13b für MOS-Transistoren gefertigt. Die Wortleitungen 13a verlaufen quer zu den Isolationsbereichen 4.

Alternativ kann, wie es in Figur 3 dargestellt ist, eine Gatepolysiliziumschicht 14, die entweder direkt dotiert ist oder über Implantation oder POCL-Belegung dotiert wird, abgeschieden und mit einer weiteren SiO₂-Schicht 15 abgedeckt werden, welche beispielsweise in einem TEOS-Verfahren mit im wesentlichen konformer Kantenbedeckung abgeschieden wird. Diese Anordnung kann gemäß Figur 3 vermittels eines anisotropen Ätzmittels strukturiert werden.

Daran anschließend werden zur Fertigstellung der Speichertransistoren T1, T2 und der lateralen MOS-Transistoren T3 in der Peripherie 6 durch konforme Abscheidung und anisotrope Ätzung einer SiO₂-Schicht an den senkrechten Flanken der Wortleitungen 13a sowie der Gateelektroden 13b SiO₂-Spacer 16 erzeugt. Durch Implantation mit zum Beispiel Arsen bei einer Energie von 50 keV mit einer Dosis von 5 x 10¹⁵cm⁻³ werden im Speicherzellenfeld 5 Draingebiete 17, 18 und in der Peripherie 6 Source/Draingebiete 19, 20 gebildet. Da die Gebiete 17 bis 20 der MOS-Transistoren im Speicherzellenfeld 5 und in der Peripherie 6 vom gleichen Leitfähigkeitstyp, beispielsweise n⁺-Typ dotiert sind, und im übrigen gleich dotiert sind wie die Gateelektrode 13b und die Wortleitungen 13a, kann diese Implantation ohne zusätzliche Maske erfolgen. Ferner können zur Herstellung der lateralen MOS-Transistoren in dem Peripheriebereich 6 weitere, aus der MOS-Technik an sich bekannte Verfahrensschritte wie Einstellung eines LDD-Profils, Salizide-Technik und ähnliches durchgeführt werden.

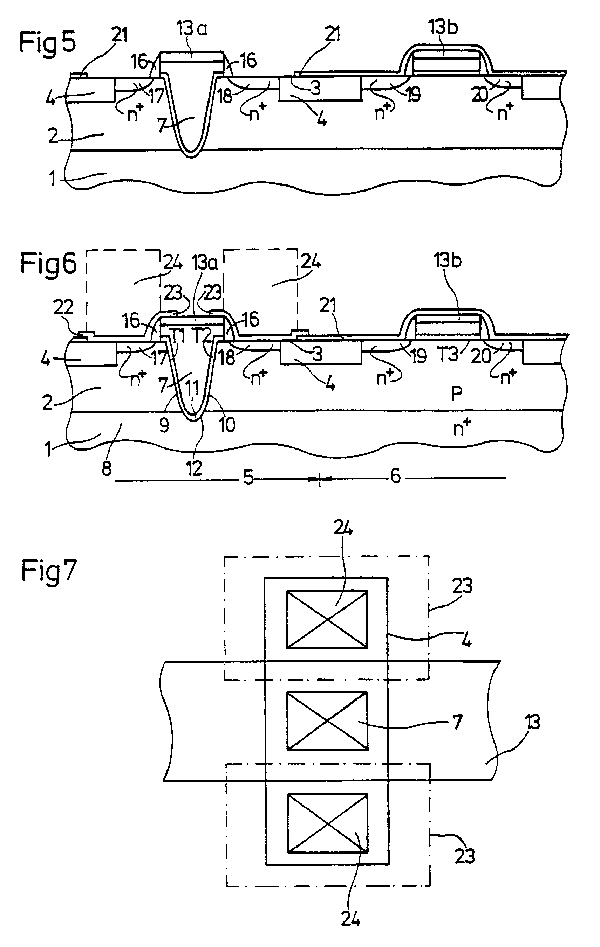

Unter Bezugnahme auf die Figuren 5 und 6 wird im folgenden die Herstellung von lokalen Zwischenverbindungen für den elektrischen Anschluß der Draingebiete 17, 18 der Grabentransistoren T1, T2 mit Kontaktlöchern beschrieben, welche derart angeordnet werden, daß ein Überlapp eines später gefertigten Kontaktloches zu den Gate- und Isolationskanten auf Null reduziert und damit die Packungsdichte der Speicherzellen weiter erhöht werden kann. Gemäß Figur 5 wird in einem TEOS-Verfahren zunächst eine SiO₂-Schicht 21 mit im wesentlichen konformer Kantenbedeckung abgeschieden. Unter Verwendung einer entsprechend strukturierten Maske werden anschließend die zu kontaktierenden Draingebiete 17, 18 geöffnet, d.h. an diesen Stellen wird die SiO₂-Schicht 21 entfernt, beispielsweise in einem zu Silizium selektiven Ätzverfahren mit beispielsweise CHF₃, CF₄, Ar, bis die Oberfläche des zweiten dotierten Gebietes 2 freigelegt ist. Daran anschließend wird ganzflächig eine elektrisch leitfähige Schicht 22 aufgebracht und unter Verwendung einer weiteren (nicht näher dargestellten) Maske derart strukturiert (siehe Figur 6), daß eine lokale, d.h. kurzreichweitige Zwischenverbindung 23 an den Stellen stehen bleibt, wo die später zu fertigenden, in der Figur 6 schematisch mit der Bezugsziffer 24 angedeuteten Kontaktlöcher ausgebildet werden. Das Material der lokalen Zwischenverbindung 23 umfaßt vorzugsweise Polysilizium, welches entweder in dotierter Form abgeschieden oder nach der Abscheidung durch Implantation oder Belegung dotiert wird. Daneben sind auch andere Materialien wie beispielsweise Polyzide oder Silizide mit günstigen hochtemperaturstabilen Eigenschaften verwendbar. Die lokale Zwischenverbindung 23 dient als Verbreiterung der nur eine geringe Anschlußfläche aufweisenden Drainbereiche 17, 18, so daß zum einen ein sicherer Anschluß des prozeßbedingt eine gewisse Breite aufweisenden Kontaktloches 24 an das Draingebiet 17, 18, und zum anderen eine größere Packungsdichte durch Vermeiden eines Überlapps des Kontaktloches 24 zu den Gateisolationskanten ermöglicht wird (siehe auch die schematische Draufsicht gemäß Figur 7).

Zur Fertigstellung der Festwert-Speicherzellenanordnung wird anschließend ganzflächig eine planarisierende Zwischenoxidschicht zum Beispiel aus Bor-Phosphor-Silikatglas abgeschieden, in der die Kontaktlöcher 24 geöffnet werden. Anschließend werden die Kontaktlöcher 24 beispielsweise mit Wolfram aufgefüllt. Es folgt die Erzeugung einer Metallisierungsebene zum Beispiel durch Abscheidung und Strukturierung einer Alumiumschicht. Schließlich wird eine Passivierungsschicht aufgebracht. Dabei wird auch das Substrat 1 mit einem Kontakt versehen. Diese Standardschritte sind nicht im einzelnen dargestellt.

Bei dem erfindungsgemäßen Herstellungsverfahren werden sieben Masken benötigt, wobei gleichzeitig mit dem Zellenfeld 5 laterale Transistoren in der Peripherie 6 hergestellt werden. Der Flächenbedarf einer Speicherzelle beträgt in diesem Ausführungsbeispiel 4F², wobei F die in der jeweiligen Lithographie kleinste herstellbare Strukturgröße darstellt.

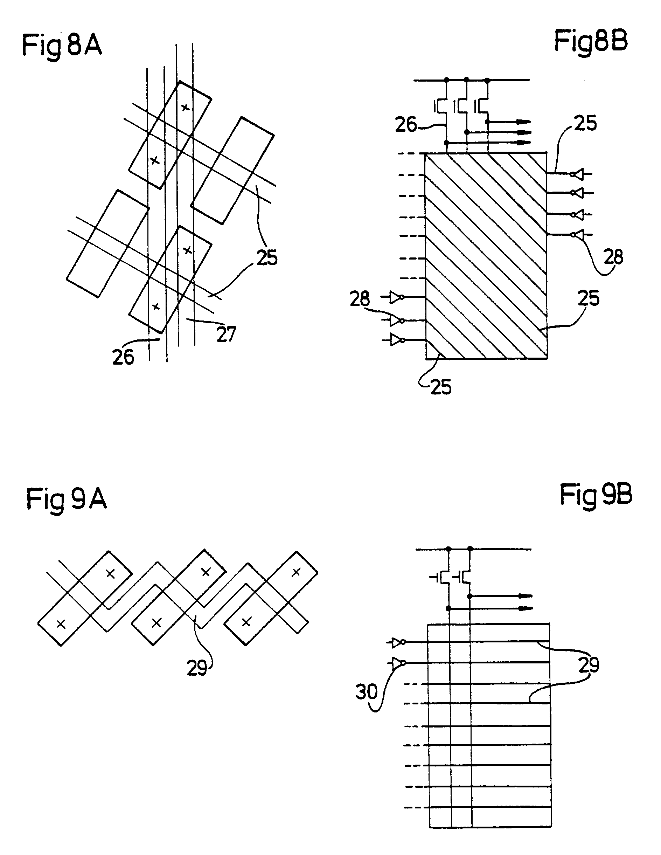

In den Figuren 8A, 8B und 9A, 9B sind bevorzugte Anordnungen der Bitleitungen und Wortleitungen über ein gesamtes Zellenfeld in schematischer Draufsicht dargestellt. Bei den Figuren 8A und 8B sind die Bitleitungen 25 in diagonaler Anordnung im Zellenfeld 5 geführt, wobei die Wortleitungen 26, 27 in geradliniger Anordnung geführt sind. Bei dieser Anordnung der Speicherzellen und der Wort- und Bitleitungen ist die Packungsdichte der Speicherzellen am größten. Nachteil bei dieser Anordnung ist jedoch die aufgrund der diagonalen Führung der Bitleitungen 25 am Randbereich des Speicherzellenfeldes 5 versetzt angeordnete Plazierung der Bitleitungstreiber 28, was in einem vergrößertem Platzbedarf am Peripheriebereich resultiert.

Demgegenüber zeigen die Figuren 9A und 9B eine Ausführungsform einer Festwert-Speicherzellenanordnung, bei der die einzelnen Zellen eines Feldes geradlinig ausgerichtet und die Bitleitungen 29 zickzackförmig geführt sind, so daß die Bitleitungstreiber 30 am Peripheriebereich des Zellenfeldes nebeneinander und auf einer Seite des Peripheriebereiches angeordnet sind. Auf diese Weise ergibt sich am Peripheriebereich eine gewisse Flächenersparnis, welche allerdings zu Lasten der Zellenfläche geht, welche bei dieser Ausführung etwas größer ist als bei der Anordnung gemäß den Figuren 8A und 8B.

## Patentansprüche

1. Festwert-Speicherzellenanordnung mit einem aus Halbleitermaterial bestehenden Substrat (1), welches im Bereich einer Hauptfläche (3) in einem Zellenfeld (5) angeordnete Speicherzellen aufweist,
wobei jede Speicherzelle jeweils wenigstens einen MOS-Transistor (T1, T2) mit einem Sourcegebiet (8), einem Draingebiet (17, 18), einem Kanalgebiet, einem Gatedielektrikum (11) und einer Gateelektrode (13) aufweist,
wobei das Draingebiet (17, 18) mit einer Bitleitung (25, 29) und die Gateelektrode (13) mit einer Wortleitung (26, 27) verbunden ist, und der MOS-Transistor (T1, T2) durch einen von der Hauptfläche (3) des Substrates (1) ausgehenden Graben (7), der bis zu dem Sourcegebiet (8) reicht, ausgebildet ist, und wobei die Seitenwände (9, 10) des Grabens (7) des MOS-Transistors (T1, T2) unter einem Winkel von etwa 45° bis etwa 80° gegenüber der Hauptfläche (3) des Substrates (1) angeordnet sind, und mit einem Dotiermaterial einer vorbestimmten Leitfähigkeit zur Festlegung der Programmierung des MOS-Transistors dotiert sind,
**dadurch gekennzeichnet, daß**
in dem Graben (7) zumindest zwei MOS-Transistoren (T1, T2) ausgebildet sind, die durch unterschiedliche Dotierung der beiden Seitenwände (9, 10) des Grabens (7) unterschiedlich programmiert sind, so daß jeder MOS-Transistor (T1, T2) eines Grabens (7) in einem vorbestimmten Logikzustand aus einer mehrwertige Logikzustände besitzenden Zustandslogik, insbesondere einer vierwertigen Zustandslogik programmiert ist.

2. Festwert-Speicherzellenanordnung nach Anspruch 1,
**dadurch gekennzeichnet, daß**
die in einem Graben (7) ausgebildeten zwei MOS-Transistoren (T1, T2) jeweils einen gemeinsamen Sourcebereich (8) und einen gemeinsamen Gatebereich (13) besitzen.

3. Festwert-Speicherzellenanordnung nach Anspruch 1 oder 2,
**dadurch gekennzeichnet, daß**
das Gatedielektrikum (11) ein Gateoxid (11) aufweist und die Festwert-Speicherzellenanordnung ein maskenprogrammierter Nur-Lesespeicher ist, oder das Gatedielektrikum ein ONO-Formierungsmaterial aufweist und die Festwert-Speicherzellenanordnung ein einmal elektrisch programmierbarer Nur-Lesespeicher ist.

4. Festwert-Speicherzellenanordnung nach einem der Ansprüche 1 bis 3,
**dadurch gekennzeichnet, daß**
mehr als zwei MOS-Transistoren (T1, T2) in einem Graben (7) ausgebildet sind.

5. Verfahren zur Herstellung einer Festwert-Speicherzellenanordnung mit einem aus Halbleitermaterial bestehenden Substrat (1), welches im Bereich einer Hauptfläche (3) in einem Zellenfeld (5) angeordnete Speicherzellen aufweist,
wobei jede Speicherzelle jeweils wenigstens einen MOS-Transistor (T1, T2) mit einem Sourcegebiet, einem Draingebiet, einem Kanalgebiet, einem Gatedielektrikum und einer Gateelektrode (13b) aufweist, wobei das Draingebiet mit einer Bitleitung und die Gateelektrode (13b) mit einer Wortleitung verbunden ist, und der MOS-Transistor (T1, T2) durch einen von der Hauptfläche (3) des Substrates (1) ausgehenden Graben (7), der bis zu dem Sourcegebiet reicht, ausgebildet ist,
und wobei die Seitenwände (9, 10) des Grabens (7) des MOS-Transistors (T1, T2) unter einem Winkel von etwa 45° bis etwa 80° gegenüber der Hauptfläche (3) des Substrates (1) angeordnet sind,
**dadurch gekennzeichnet, daß**
daß in dem Graben (7) zumindest zwei MOS-Transistoren (T1, T2) ausgebildet werden, die durch unterschiedliche Dotierung der beiden Seitenwände des Grabens (7) unterschiedlich programmiert werden, so daß jeder MOS-Transistor (T1, T2) eines Grabens (7) in einem vorbestimmten Logikzustand aus einer mehrwertige Logikzustände besitzenden Zustandslogik, insbesondere einer vierwertigen Zustandslogik programmiert wird.

6. Verfahren nach Anspruch 5,
**dadurch gekennzeichnet, daß**
die in einem Graben (7) ausgebildeten zwei MOS-Transistoren (T1, T2) jeweils einen gemeinsamen Sourcebereich und einen gemeinsamen Gatebereich besitzen.

7. Verfahren nach Anspruch 5 oder 6,
**dadurch gekennzeichnet, daß**
das Gatedielektrikum ein Gateoxid (11) aufweist und die Festwert-Speicherzellenanordnung ein maskenprogrammierter Nur-Lesespeicher ist, oder das Gatedielektrikum ein ONO-Formierungsmaterial aufweist und die Festwert-Speicherzellenanordnung ein einmal elektrisch programmierbarer Nur-Lesespeicher ist.

8. Verfahren nach einem der Ansprüche 5 bis 7,
**dadurch gekennzeichnet, daß**
mehr als zwei MOS-Transistoren (T1, T2) in einem Graben (7) ausgebildet werden.

## Claims

1. Read only memory cell arrangement having a substrate (1) which is composed of semiconductor material and has memory cells arranged in a cell array (5) in the area of a main surface (3),
with each memory cell each having at least one MOS transistor (T1, T2) with a source region (8), a drain region (17, 18), a channel region, a gate dielectric (11) and gate electrode (13),
with the drain region (17, 18) being connected to a bit line (25, 29), and the gate electrode (13) being connected to a word line (26, 27), and the MOS transistor (T1, T2) being formed by a trench (7) which originates from the main surface (3) of the substrate (1) and extends as far as the source region (8),
and with the side walls (9, 10) of the trench (7) in the MOS transistor (T1, T2) being arranged at an angle from approximately 45° to approximately 80° with respect to the main surface (3) of the substrate (1), and being doped with a doping material with a predetermined conductivity in order to define the programming of the MOS transistor,
**characterized in that**
at least two MOS transistors (T1, T2) are formed in the trench (7) and are programmed differently by different doping of the two side walls (9, 10) of the trench (7) such that each MOS transistor (T1, T2) of a trench (7) is programmed with a predetermined logic state from state logic which has logic states with a number of values, in particular 4-value state logic.

2. Read only memory cell arrangement according to Claim 1,
**characterized in that**
the two MOS transistors (T1, T2) which are formed in a trench (7) each have a common source region (8) and a common gate region (13).

3. Read only memory cell arrangement according to Claim 1 or 2,
**characterized in that**
the gate dielectric (11) has a gate oxide (11), and the read only memory cell arrangement is a mask-programmed read only memory and the gate dielectric has an ONO forming material and the read only memory cell arrangement is a read only memory which can be programmed once electrically.

4. Read only memory cell arrangement according to one of Claims 1 to 3,
**characterized in that**
more than two MOS transistors (T1, T2) are formed in one trench (7).

5. Method for producing a read only memory cell arrangement having a substrate (1) which is composed of semiconductor material and has memory cells arranged in a cell array (5) in the area of a main surface (3),
with each memory cell each having at least one MOS transistor (T1, T2) with a source region, a drain region, a channel region, a gate dielectric and a gate electrode (13b), with the drain region being connected to a bit line and the gate electrode (13b) being connected to a word line, and the MOS transistor (T1, T2) being formed by a trench (7) which originates from the main surface (3) of the substrate (1) and extends as far as the source region,
and with the side walls (9, 10) of the trench (7) in the MOS transistor (T1, T2) being arranged at an angle from approximately 45° to approximately 80° with respect to the main surface (3) of the substrate (1),
**characterized in that**
at least two MOS transistors (T1, T2) are formed in the trench (7) and are programmed differently by different doping of the two side walls of the trench (7) such that each MOS transistor (T1, T2) of a trench (7) is programmed with a predetermined logic state from state logic which has logic states with a number of values, in particular 4-value state logic.

6. Method according to Claim 5,
**characterized in that**
the two MOS transistors (T1, T2) which are formed in a trench (7) each have a common source region and a common gate region.

7. Method according to Claim 5 or 6,
**characterized in that**
the gate dielectric has a gate oxide (11), and the read only memory cell arrangement is a mask-programmed read only memory, or the gate electrode has an ONO forming material and the read only memory cell arrangement is a read only memory which can be programmed once electrically.

8. Method according to one of Claims 5 to 7,
**characterized in that**
more than two MOS transistors (T1, T2) are formed in one trench (7).

## Revendications

1. Groupement de cellules de mémoire morte, comprenant un substrat (1) en un matériau semi-conducteur qui comporte dans la région d'une surface (3) principale des cellules de mémoire disposées suivant un champ (5) de cellules, chaque cellule de mémoire comportant respectivement au moins un transistor (T1, T2) ayant une zone (8) de source, une zone (17, 18) de drain, une zone de canal, un diélectrique (11) de grille et une électrode (13) de grille, la zone (17, 18) de drain étant reliée à une ligne (25, 29) de bits et l'électrode (13) de grille à une ligne (26, 27) de mots, et le transistor (T1, T2) MOS étant constitué par un sillon (7) issu de la surface (3) principale du substrat (1) et allant jusqu'à la zone (8) de source, tandis que les parois (9, 10) latérales du sillon (7) du transistor (T1, T2) MOS font un angle d'environ 45° à environ 80° avec la surface (3) principale du substrat (1) et sont dopées par une substance de dopage d'une conductivité déterminée à l'avance en vue de fixer la programmation du transistor MOS,
**caractérisé en ce qu'**il est constitué dans les sillons (7) au moins deux transistors (T1, T2) MOS qui sont programmés différemment par dopage différent des deux parois (9,10) latérales du sillon (7) de sorte que chaque transistor (T1, T2) MOS d'un sillon (7) est programmé en un état logique déterminé à l'avance d'une logique d'état ayant des états logiques plurivalents notamment d'une logique d'état tétravalent.

2. Groupement de cellules de mémoire morte suivant la revendication 1, **caractérisé en ce que** les deux transistors (T1, T2) MOS constitués dans le sillon (7) ont respectivement une zone (8) de source commune et une zone (13) de grille commune.

3. Groupement de cellules de mémoire morte suivant la revendication 1 ou 2, **caractérisé en ce que** le diélectrique (11) de grille a un oxyde (11) de grille et le groupement de cellules de mémoire morte est une mémoire pour lecture, seulement programmée par masque ou le diélectrique de grille a un matériau de formation ONO et le groupement de cellules de mémoire morte est une mémoire seulement pour lecture, qui peut être programmée une fois électriquement.

4. Groupement de cellules de mémoire morte suivant l'une des revendications 1 à 3, **caractérisé en ce qu'**il est constitué plus de deux transistors (T1, T2) MOS dans un sillon (7).

5. Procédé de fabrication d'un groupement de cellules de mémoire morte comprenant un substrat (1) en un matériau semi-conducteur qui dans la région d'une surface (3) principale comporte des cellules de mémoire disposées suivant un champ (5) de cellules, chaque cellule de mémoire comprenant respectivement au moins un transistor (T1, T2) MOS ayant une zone de source, une zone de drain, une zone de canal, un diélectrique de grille et une électrode (13b) de grille, la zone de drain étant reliée à une ligne de bits et l'électrode (13b) de grille à une ligne de mots, et le transistor (T1, T2) MOS étant constitué par un sillon (7) partant de la surface (3) principale du substrat (1) et allant jusqu'à la zone de source, et les parois (9, 10) latérales du sillon (7) du transistor (T1,T2) MOS faisant un angle d'environ 45° à environ 80° avec la surface (3) principale du substrat (1),
**caractérisé en ce qu'**il consiste à constituer dans le sillon (7) au moins deux transistors (T1, T2) MOS qui, par un dopage différent des deux parois latérales du sillon (7), sont programmés différemment de sorte que chaque transistor (T1 T2) MOS d'un sillon (7) est programmé en un état logique déterminé à l'avance d'une logique d'états ayant des états logiques plurivalents, notamment d'une logique d'états tétravalente.

6. Procédé suivant la revendication 5, **caractérisé en ce que** les deux transistors (T1, T2) MOS constitués dans un sillon (7) ont respectivement une zone de source commune et une zone de grille commune.

7. Procédé suivant la revendication 5 ou 6, **caractérisé en ce que** le diélectrique de grille comporte un oxyde (11) de grille et le groupement de cellules de mémoire morte est une mémoire à lecture seulement, programmée par masque, ou le diélectrique de grille est un matériau de formation ONO et le groupement de cellules de mémoire morte est une mémoire à lecture seulement, qui peut être programmée électriquement une fois.

8. Procédé suivant l'une des revendications 5 à 7, **caractérisé en ce qu'**il consiste à constituer plus de deux transistors (T1, T2) MOS dans un sillon (7).
